# EUROPEAN PATENT SPECIFICATION

(11) **EP 1 444 821 B1**
(45) Date of publication and mention of the grant of the patent: **20.09.2006**
(21) Application number: 01998026.7
(22) Date of filing: 14.11.2001
(51) Int. Cl.: H04M 11/06, H04L 27/00

(54) **HIGH PERFORMANCE MICRO-FILTER AND SPLITTER APPARATUS**
LEISTUNGSSTARKES MIKROFILTER UND TEILERGERÄT
APPAREIL DE MICRO-FILTRE ET DE SEPARATEUR HAUTE PERFORMANCE

(43) Date of publication of application: 11.08.2004
(73) Proprietor: Pulse Engineering, Inc., San Diego, CA 92128 (US)
(72) Inventor: KIKO, Frederick, J., Carlsbad, CA 92008 (US)
(74) Representative: Fitchett, Stuart Paul
(86) International application number: PCT/US2001/045568
(87) International publication number: WO 2003/045043

(56) References cited:
- EP-A- 0 677 938
- EP-A- 1 076 447
- US-A- 5 623 543

## Description

### Background of the Invention

### 1. Field of the Invention

The present invention relates generally to electronics used in telecommunications applications, and particularly to an improved filter and splitter apparatus and methods for use in a digital subscriber line (DSL) or similar telecommunications system.

### 2. Description of Related Technology

Today, Asymmetrical Digital Subscriber Line (ADSL) installations are mostly what is known as "self-install", or specifically where the subscriber installs a micro-filter or in-line phone filters on each telephone to isolate the phones (including faxes, answering machines, etc.) from the line and the ADSL signal path. Fig. I illustrates a typical installation of such in-line filters.

The self-installable micro-filter is a challenging design, largely because it must have sufficient stop band in the DSL band to protect and preserve DSL performance, but at the same time should also have negligible effect on the voice band performance.

EP-A-1 076 447 and Fig. 1a illustrate typical prior art in-line filter configurations used in DSL applications. Such prior art filter designs, however, often do not satisfy some of the telecom customer's requirements for both return loss and DSL stop band. One significant problem is that the total capacitance required for the DSL stop band requirements also produce excessive side tone in the upper band of the telephones, a highly undesirable result. Furthermore, the return loss problem becomes worse as more micro-filters are added for each of the subscriber's phones.

United Kingdom (UK) and European filter circuit requirements are more stringent. One major challenge in this regard is providing the 30 KHz stop band while providing the very high voice band return loss.

Based on the foregoing, an improved apparatus and method for filtering digital subscriber line (DSL) signals is needed. Such improved apparatus and methods would (i) be readily installed and implemented by the subscriber, (ii) make use of existing telecommunications and/or power line infrastructure, (iii) provide enhanced stop band and return loss performance with no penalty on other aspects of circuit performance, and (iv) be compatible with and/or adaptable to a number of different applications and prevailing telecommunications specifications, thereby providing, *inter alia,* maximum manufacturing flexibility.

### Summary of the Invention

The present invention satisfies the aforementioned needs by providing an improved digital subscriber line communications filter and splitter apparatus, and method of operating the same.

In a first aspect of the invention, there is provided telecommunications signal conditioning apparatus adapted to provide both enhanced stop band attenuation and enhanced voice band return loss performance, comprising:
first terminals adapted to interface with a first telecommunications line, said telecommunications line being adapted to carry signals having first and second components;
second terminals adapted to interface with an extension device;
impedance correction apparatus in electrical communication with said first terminals and adapted to alter return loss with respect to said voice component of said signals, said impedance correction apparatus comprising at least one parallel RLC circuit; and
signal filter apparatus comprising at least first and second parallel LC circuits disposed electrically between said second terminals and said impedance correction apparatus said filter apparatus further comprising switching apparatus disposed electrically between said first and second parallel LC circuits and adapted to selectively alter the configuration of said signal filter apparatus so as to increase the capacitance of said filter apparatus, said increase in capacitance providing at least in part said enhanced stop band attenuation.

In one embodiment, the application comprises an asymmetric digital subscriber line (ADSL) and associated Telco wiring having a plurality of extension jacks, and the apparatus comprises one or more dynamic filter circuits interposed between the extension jacks (e.g. wall jack) and the subscriber's associated extension devices (telephone, answering machine, etc.). Each filter circuit comprises an input portion, impedance correction portion, and dynamic-response portion. In one exemplary variant, the circuit comprises a fourth order filter with an input section comprising a plurality of series inductors, and an impedance correction portion comprising a plurality of parallel RLC networks disposed in parallel with the inductors. Dynamic circuit elements (e.g. reed switches which are magnetically coupled to one or more of the inductors in the circuit) are used to vary the configuration, and therefore response, of the circuit when the extension device state changes, such as in going from an "on hook" to "off hook" condition. For example, when the extension device goes off hook, the associated filter circuit dynamically increases its capacitance in relation to the other on hook extension devices, thereby providing enhanced signal performance. Additionally, to protect the dynamic circuit elements from ringing voltage, protective elements (e.g. Zener diodes or varistors) are employed in the circuit to clamp the voltage to an acceptable level.

The foregoing circuit can be adapted to function as an improved signal splitter device for use in applications having master jack wiring. The splitter device includes the aforementioned input and impedance correction portions, yet without the dynamic portion of the circuit. The impedance correction portion, coupled with the higher order (e.g. fourth order elliptical) filter, provides enhanced splitter performance as compared to existing prior art designs.

In a second aspect of the invention, there is provided a method of conditioning a digital subscriber line (DSL) signal flowing through a circuit as previously referenced so as to both at least predetermined minimum levels of stop band attenuation above a predetermined frequency, and voice band return loss greater than a predetermined minimum value, the method comprising:
filtering at least a portion of said signal;
switching at least a portion of said filter circuit, said act of switching selectively altering the configuration of said filter circuit so as to provide at least in part said minimum level of stop band attenuation; and
selectively adjusting the impedance of said circuit to provide said return loss greater than said minimum value.

In one embodiment, the method can comprise providing telecommunications signals having both first and second components; filtering at least a portion of the signals; and dynamically varying the capacitance of the circuit based at least in part on the magnitude of current flowing through at least a portion of the circuit. In another embodiment, the method further comprises selectively adjusting the impedance of the circuit to alter the return loss of the signals, thereby enhancing circuit (and system) performance.

In a fourth aspect of the invention, a telecommunications system architecture incorporating the improved filter or splitter apparatus previously described is disclosed.

### Brief Description of the Drawings

The features, objectives, and advantages of the invention will become more apparent from the detailed description set forth below when taken in conjunction with the drawings, therein.

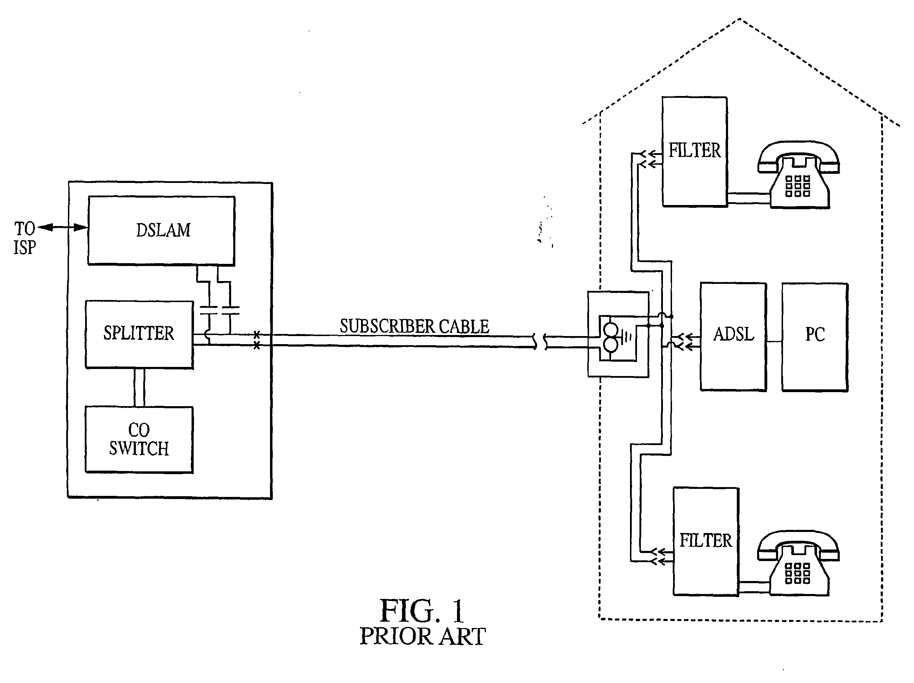

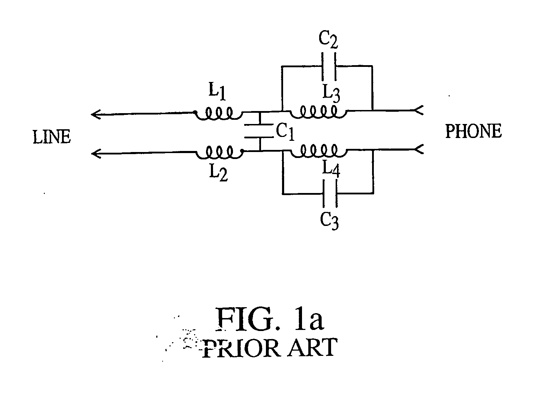

Fig. 1 is a block diagram of a typical prior art ADSL installation in a home or small business environment, including prior art micro-filters, installed on multiple phone extensions.
Fig. 1a is a schematic of the prior art DSL micro-filters show in Fig. 1.
Fig. 2 is a schematic of one exemplary embodiment of the dynamic micro-filter circuit of the present invention, adapted for use with a multi-terminal telecommunications jack and extension device.
Fig. 2a is a top plan view of a first embodiment of a dual winding inductor/reed switch device for use in the filter circuit of Fig. 2.
Fig. 2b is a side elevational view of the dual winding device of Fig. 2a.
Fig. 2c is an end view of a second embodiment of the dual winding inductor/reed switch device for use in the circuit of Fig. 2.
Fig. 2d is a side elevational view of the dual winding inductor device of Fig. 2c.
Fig. 3 is a schematic of a second embodiment of the filter circuit of the invention, adapted for use as a splitter in applications having with master jack wiring.
Figs. 4a - 4c are top, front, and rear plan views of one exemplary embodiment of a filter housing used in conjunction with the filter circuits of Figs. 2 and 3.
Fig. 5 is a block diagram illustrating one exemplary embodiment of the telecommunications system architecture of the invention, including dynamic filter circuits.

### Detailed Description of the Preferred Embodiment

Reference is now made to the drawings wherein like numerals refer to like parts throughout.

As used herein, the term "signal conditioning" or "conditioning" shall be understood to include, but not be limited to, signal voltage transformation, filtering and noise mitigation, signal splitting, impedance control and correction, current limiting, capacitance control, and time delay.

It is noted that while portions of the following description is cast in terms of RJ-type connectors and associated modular plugs of the type well known in the telecommunications art, the present invention may be used in conjunction with any number of different connector types. Accordingly, the following discussion is merely exemplary of the broader concepts.

Additionally, the terms "site" and "subscriber's site" as used herein shall include any location (or group of locations) having telecommunications line service provided thereto, including without limitation residential houses, apartments, offices, and businesses.

Lastly, as used herein, the term "extension device" is meant to include any type of telecommunications device compatible with use on existing telecommunications lines, including without limitation conventional telephones, answering machines, facsimile machines, wireless or satellite receivers, and multi-line phones.

### Overview

The present invention solves the problems of inadequate stop band and voice band performance on telecommunications lines by advantageously providing (i) a "dynamic" filter configuration which can change states dependent on the operating condition of the associated extension devices; and (ii) an impedance correction circuit which provides, *inter alia*, enhanced return loss performance. Specifically, in the case of a telecommunications line having voice and DSL signal components, when one of the phones on the line goes "off hook" (typically only one of the phones are off hook at any one time), the dynamic circuitry of the off hook filter increases its capacitance, while all the other "on hook" phones on the same line remain at a low capacitance relative to the off hook circuit. This dynamic capacitance feature is acceptable and compatible with existing applications, since the primary need for the enhanced DSL stop band corresponds to the off hook phone, and the presence of the phone's polarity guard diode bridge. The DSL high-level up stream energy can over-drive this diode bridge in the off hook phones, and accordingly produce unwanted inter-modulation distortion. Therefore, enhanced DSL stop band is needed to prevent such over-drive condition. When the phone or other extension device is on hook, the diode bridge is removed from the circuit, and less filter DSL stop band attenuation is required. Very little capacitance can therefore be employed in the filter circuits associated with the on hook phones. This allows the off hook phone to have a comparatively larger capacitance, and thus the dynamic filter can have near splitter performance.

Additionally, the filter and splitter circuits of the present invention includes a novel impedance correction circuitry on the line side of the circuit in order to further improve the voice band return loss and the phone's side tone, and therefore support prevailing European telecommunications standards and objectives.

### Filter Circuit Description

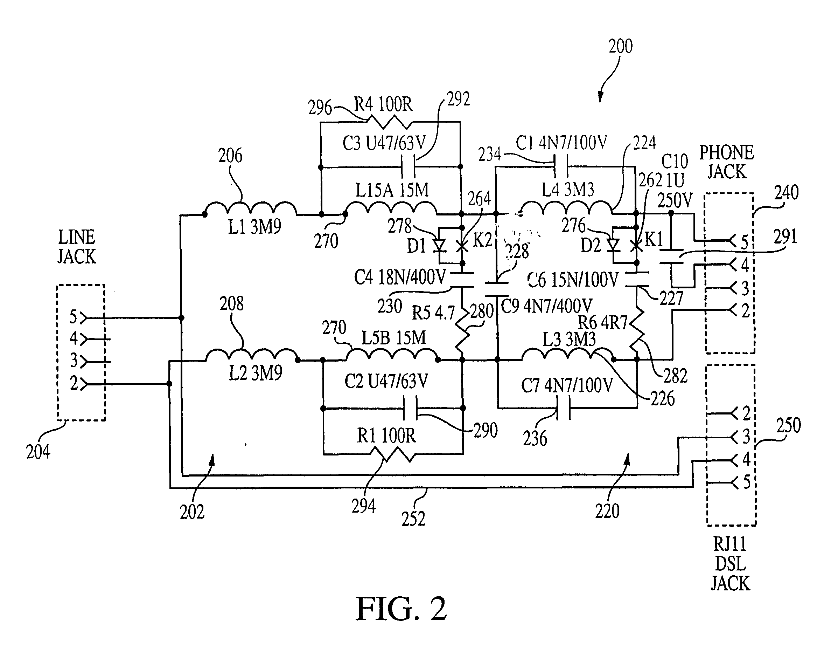

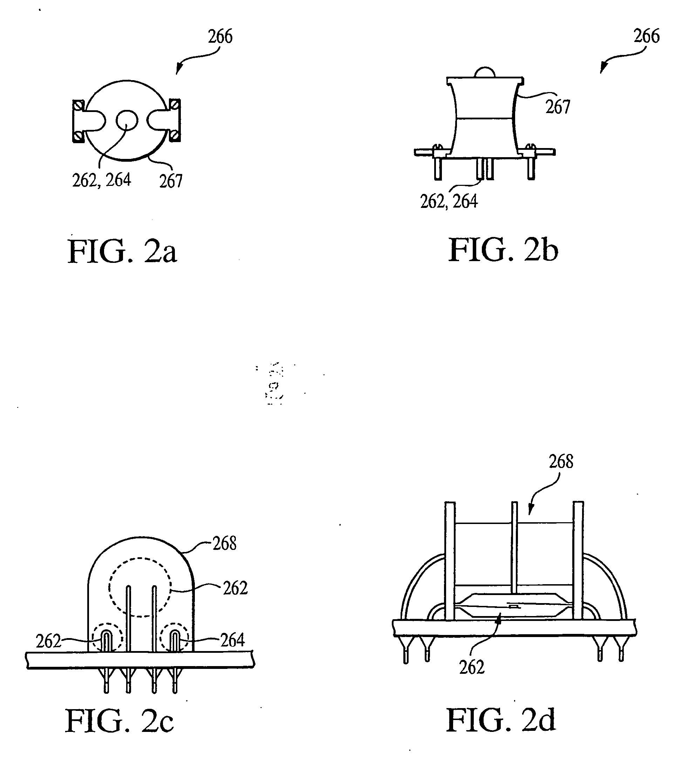

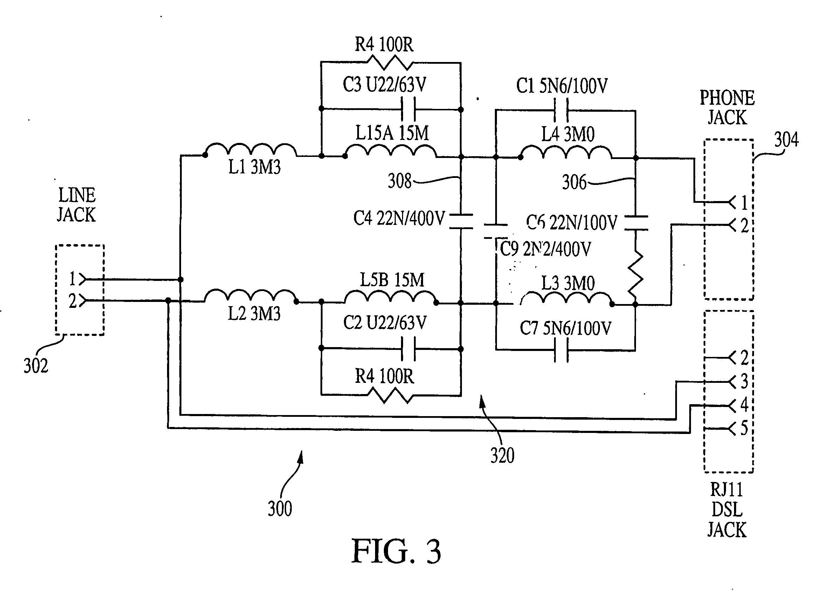

Referring now to Fig. 2, a first embodiment of the dynamic micro-filter configuration of the invention is described. It will be appreciated that while the embodiment of Fig. 2 comprises an exemplary design adapted to meet the requirements for use in the United Kingdom (UK), the dynamic filter of the present invention may be adapted for use in literally any application, such as that of Fig. 3 herein (adapted for use in Sweden), or other countries, through proper component selection and configuration. Such alternate applications and adaptations are readily determinable to those of ordinary skill based on the present disclosure, and accordingly are not described further herein.

It will further be appreciated that while the following discussion is cast in terms of a plurality of discrete electrical components (i.e., resistors, inductors, capacitors, switches, etc.) used to form a circuit, portions of the circuit may be rendered in the form of integrated components (such as integrated circuits) or other types of components having the desired functionality and electrical performance.

As shown in Fig.2, the filter circuit 200 generally comprises an input section 202 having a plurality of input terminals (line side jack) 204 and two input inductors 206, 208. An output section 220 comprises two additional inductors 224, 226 (L3 , L4) and three capacitors 227, 228, 230 (C4, C9, C6). The filter's input inductors (L1, L2) 206, 208 are connected to the line side jack 204, while the filter's capacitive output section 220 is connected to the filter's phone side jack 240. The line and phone side jacks 204, 240 a UK-type modular jack of the type commonly used in the United Kingdom, although it will be recognized that other types of modular plugs and connectors may be substituted. The filter 200 further includes a DSL jack 250 that, in the illustrated embodiment, comprises and RJ-11 type DSL jack, although others may be substituted as well. The DSL jack 250 passes directly via electrical pathways 252 to the line side jack 204 (or plug) to provide a convenience DSL or home phone network (HPN) jack.

The basic filter provided by the circuit of Fig. 2 is a fourth-order elliptical low pass filter that consists of the two input inductors 206, 208 (L1, L2), two output section inductors 224, 226 (L3, L4), and three bridge capacitors 227, 228, 230 (C4, C9, and C6, respectively). The input inductors 206, 208 provide the required input inductance to prevent loading on the DSL circuit, while the two capacitors 234, 236 (C1, C7) in the output section 220 are added to the output inductors 224, 226 (L3, L4) to produce a resonance on the order of 30 KHz, although it will be appreciated that other resistance and capacitance values can be selected in order to obtain other resonance frequencies. Accordingly, the embodiment of Fig. 2 is a fourth-order elliptical filter which produces a sharp 30 KHz cut-off. The elliptical stop band feature allows the design to minimize the total capacitance to typically < 40 nF (i.e., < 40E-09 Farad), which minimizes the effect of the capacitance on the phone's voice band performance.

### Dynamic Components

To make the filter 200 dynamic and allow for self-installation by the subscriber for multiple filters for each telephone, two reed switches 262, 264 (K1, K2) are added to remove most of the filter capacitance for the on hook (idle) phones. Both of the reed switches 262, 264 are, in the embodiment of Fig. 2, magnetically coupled to the dual inductor 270 (L5A), as described in U.S. Patent Nos. 6,181,777 and 6,212,259 entitled "Impedance Blocking Filter Circuit", issued January 30, 2001 and April 3, 2001, respectively, and assigned to Assignee hereof. Specifically, the reed switches 262, 264 are coupled to the dual inductor 270 by virtue of their physical proximity to the windings of the inductor, and therefore the magnetic field generated thereby.

Figs. 2a and 2b illustrate one exemplary configuration for a dual inductor/reed switch device 266 compatible with the circuit of Fig. 2 and incorporating the dual inductor 270 and reed switches 262, 264. The inductor/reed switch device 266 is formed of cylindrical housing 267 and contains the dual inductor 270 and the two reed switches 262, 264. It should be apparent to those skilled in the art that the dual inductor/reed switch device 266 can be replaced with two single inductor/switch units (not shown) so as to render the same functionality. In the illustrated embodiment, the reed switches 262, 264 are disposed horizontally with their longitudinal axis substantially parallel with that of the bobbin 268. This configuration provides the aforementioned magnetic coupling between the windings of the inductor 270 and the switches to operate the latter. The device 266 of Figs. 2a-2b is selected to be actuated on a predetermined loop current threshold (e.g., approximately 6-16 mA). If the loop current threshold is too low, the reed switch(es) may chatter during operation of the circuit, and may thus shorten the useful life of the switch(es). On the other hand, if the loop current threshold is too high, then the amount of loop current may be insufficient to actuate the switch(es) in the worst case condition.

Figs. 2c and 2d illustrate a second embodiment of a dual winding inductor/reed switch device 266 according to the invention. In this embodiment, the reed switches 262, 264 are disposed centrally within the interior region of the windings. It will be appreciated to those of ordinary skill in the magnetic component arts that any number of different physical configurations for the dual inductor/reed switches may be used consistent with the circuit of Fig. 2. The foregoing embodiments are therefore merely illustrative of the broader concepts.

When no loop current flows (because the phone is on hook), there is no magnetic field from the dual inductor 270 and the reed switches 262, 264 are open, which removes the capacitors 227, 230 (C4 and C6) from the circuit. This reduces the total capacitance for each on hook filter from approximately 37.7 nF to only 4.7 nF in this embodiment. The 4.7nF value is the minimum capacitance necessary to force any on hook phone resonance below 30 KHz. Additionally, to protect the reed switches 262, 264 from the ringing voltage, power cross-voltages and lightning induced transient voltages, two Zener diodes 276, 278 (D1, D2) are included across the reed switches 262, 264 as shown in Fig. 2 to clamp the peak voltage to below 12 V. The single diodes 276, 278 of the illustrated embodiment work satisfactorily because the capacitors are in series with the diodes, and will self bias the single diode when AC signals are present. Alternatively, however, the foregoing diode arrangement may be replaced dual back-to-back 6-12 V Zener diodes, or even low capacitance varistors. The construction and selection of such components, consistent with the present aims of providing the minimum capacitance in the device, are well known in the electronics arts, and accordingly are not described further herein.

To protect the reed switches 262, 264 from switching current spikes through the C9 capacitor 228 and the C4 capacitor 227 (and the C1, C7 capacitors 234, 236) when the reed switches close, two resistors 280, 282 (R5, R6) are added in series with the C4 and C6 capacitors 226, 230 to limit the switching current to below the maximum current ratings of the switches. The resistance values of R5, R6 are chosen low enough so as not to significantly affect the filters stop band performance.

### Impedance Correction

The foregoing dynamic components of the filter 200 are collectively insufficient to provide enough return loss improvement to meet the requirements of the European/UK Specifications previously described. To address this issue, the resonant impedance correction circuit made from the dual inductor 270 (L5A, L5B), parallel network capacitors 290, 292 (C2, C3), and parallel network resistors 294, 296 (R4, and R1) further improves the voice band return loss up to 10 db by adding a positive phase impendence in the 2-3 KHz band. The dual inductor 270 (L5A, L5B) performs a dual purpose; in addition to driving the reed switches during off hook as previously described, the dual inductor 270 (in combination with the network capacitors C2, C3 290, 292) forms a differential resonance impedance in series with the line input. The parallel network resistors 294, 296 (R3, R4) limit this impedance to approximately 200 ohms at resonance, which limits the maximum insertion loss to an acceptable level (i.e., on the order of 2 db).

The circuit 200 of Fig. 2 is further provided with a 1 microfarad ringing capacitor 291 (C10) across pins 4 and 5 of the phone jack 240. Filters used in UK applications require such a capacitor for ringing some three-wire phone installations. It will be recognized, however, that this capacitor is optional depending on the particular application in which the filter circuit of the invention is used.

It is further noted that the circuit 200 embodiment of Fig. 2 advantageously uses separate inductive coils for the various circuit inductors 206, 208, 224, 226 (L1, L2, L3, L4) rather than, for example, the dual EP 13 style inductor typically used in many prior art designs. This arrangement provides a longitudinal blocking impedance as well as differential impedances, which some applications (including for example, European telecommunications specifications) require. Traditional EP-based designs have effectively no longitudinal impedance, so an additional coil is required. The additional coil adds extra DC resistance, and to compensate for the added resistance, larger coils are often required, thereby increasing the cost and space requirements associated with the filter. In contrast, with the separate coils design of the present invention, it is not necessary to add a longitudinal coil or increase the size of the filter's inductors. In the illustrated embodiment, the dual bobbin, dual shielded inductors such as those manufactured by the Assignee hereof can provide the aforementioned longitudinal impedance as well as providing magnetic field to drive the reed switches. The construction and operation of these dual bobbin, dual inductors is described in detail in the aforementioned application and as specifically set forth in preceding sections of this application. It will be recognized, however, that inductors/impedances other than the dual bobbin, dual shielded type previously referenced may be used with success in the circuit 200 of Fig. 2. For example, the aforementioned EP-type inductors could be substituted; however, the attendant disadvantages of added coil, DC resistance, and inductor coil size would be present.

Referring now to Fig. 3, a second embodiment of the improved micro-filter apparatus of the present invention is described. This second embodiment 300 is particularly useful in single splitter application also having master jack wiring, such as is currently in use in Sweden. As shown in Fig. 3, the line jacks 302 and phone jack 304 are configured to interface with the two-wire systems of Sweden (in contrast to the four-wire variants in the UK as embodied in the circuit 200 of Fig. 2). The 1 microfarad ringing capacitor 291 (C10) across pins 4 and 5 of the UK phone jack is also obviated in the present embodiment. Additionally, in the embodiment of Fig. 3, the reeds 262, 264 and diodes 276, 278 of the circuit 200 of Fig. 2 are removed and replaced with short circuits 306, 308. The non-dynamic filter 300 functions as a splitter, and is simply plugged into the masterjack located in the house or other installation site as a self-install splitter. As previously described with respect to Fig. 2, the impedance correction portion 320 of the circuit produces a splitter with superior return loss performance.

### Housing

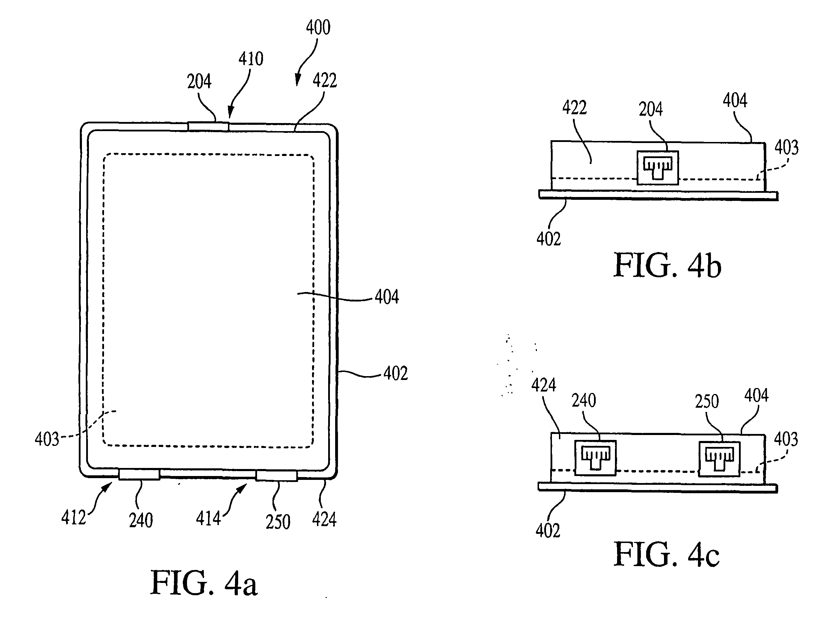

Referring now to Figs. 4a-4c, one embodiment of a filter housing adapted to receive the filter or splitter circuits 200, 300 of the present invention is described. The housing 400 comprises a polymeric base plate 402 (such as ABS plastic) and cover 404 which collectively form a cavity (not shown) within which the filter/splitter circuit 200, 300 is received. The circuit is disposed on a circuit board 403 received in the cavity and restrained by the base plate 402 and cover 404 when the housing is assembled. In the illustrated embodiment (adapted for UK installation), the housing 400 further includes a two- or four-terminal line side plug or jack 204, two or four-terminal phone side plug or jack 240, and RJ-11 DSL jack 250 disposed within respective apertures 410, 412, 414 formed in the front and rear sides 422, 424 of the housing cover 404. In the case of the circuit 300 of Fig. 3, the four-terminal jacks 204, 240 would be replaced with two-terminal jacks. Alternatively, the housing (and associated filter/splitter circuit) could be configured with three RJ-11 jacks, two RJ-45 jacks and an RJ-11 DSL jack, or any number of other permutations apparent to those of ordinary skill.

The housing can be mounted in literally any orientation and configuration desired including, for example, as a wall-mounted unit, or as a "free floating" (i.e., un-mounted) in-line unit. It will further be recognized that the housing (and filter circuit) may be adapted as other configurations, such as dual jack housings, cord and multiple jack housings, or cord and single jack housings. The housings and/or filter/splitter circuits may be ganged as well. Additionally, other signal conditioning devices may be incorporated within the housing (whether electrically or physically interfaced with the aforementioned circuits or otherwise) if so desired, consistent with electrical noise and physical space limitations.

### System

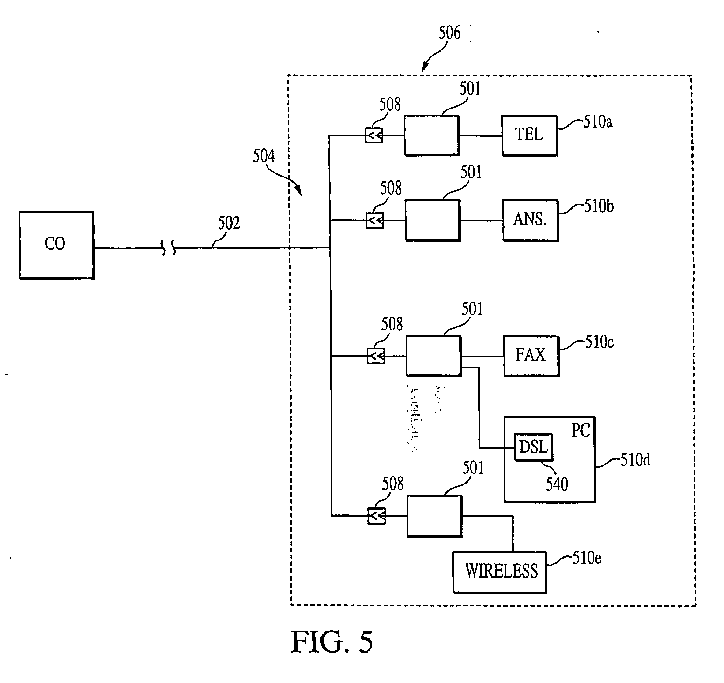

Referring now to Fig. 5, a telecommunications architecture employing the filter(s) previously described herein is disclosed. As shown in Fig. 5, the improved architecture 500 comprises (i) a telecommunications line 502 adapted for carrying DSL and voice signals to one or more distant ends 504; (ii) a local (site) telecommunications infrastructure 506 comprising a plurality of extensions (jacks) 508 accessible by the subscriber; (iii) a plurality of filter (or splitter) circuits 501 electrically interfaced with respective ones of the jacks 508; and (iv) a plurality of extension devices 510 electrically interfaced with respective ones of the filter circuits 501. The illustrated extension devices 510 comprise a standard telephone 510a, telephone with answering machine 510b, facsimile machine 510c, personal computer (PC) 510d with DSL modulator/demodulator apparatus 540, and wireless interface 510e, although other types of devices and combinations may be used. The individual filter circuits 501 are housed in respective housings of the type shown in Fig. 4 herein, and are made self-installable by the subscriber, such as through use of modular jack connections between the extension jacks 508, filter circuits 501, and extension devices 510.

As previously described, in the case of the dynamic filter circuit 200 of Fig. 2, an off hook condition present on one of the extension devices 510a-c generates a loop current which alters the reed switch position, thereby elevating the effective capacitance seen at the telecommunications extension jack 508 associated with that extension device. This advantageously permits the off hook filter circuit to have near splitter performance.

It is also noted that for a non-master jack facility or home, distributed dynamic filters may be utilized.

While the above detailed description has shown, described, and pointed out novel features of the invention as applied to various embodiments, it will be understood that various omissions, substitutions, and changes in the form and details of the device or process illustrated may be made by those skilled in the art without departing from the invention. The foregoing description is of the best mode presently contemplated of carrying out the invention. This description is in no way meant to be limiting, but rather should be taken as illustrative of the general principles of the invention. The scope of the invention should be determined with reference to the claims.

## Claims

1. Telecommunications signal conditioning apparatus adapted to provide both enhanced stop band attenuation and enhanced voice band return loss performance, comprising:
first terminals (204) adapted to interface with a first telecommunications line, said telecommunications line being adapted to carry signals having first and second components;
second terminals (240) adapted to interface with an extension device;
impedance correction apparatus (270, 290, 292, 294, 296) in electrical communication with said first terminals (204) and adapted to alter return loss with respect to said voice component of said signals, said impedance correction apparatus comprising at least one parallel RLC circuit; and
signal filter apparatus (200) comprising at least first and second parallel LC circuits (224, 234, 226, 236) disposed electrically between said second terminals (240) and said impedance correction apparatus (270, 290, 292, 296) said filter apparatus (200) further comprising switching apparatus (262) disposed electrically between said first and second parallel LC circuits (224, 234, 226, 236) and adapted to selectively alter the configuration of said signal filter apparatus so as to increase the capacitance of said filter apparatus, said increase in capacitance providing at least in part said enhanced stop band attenuation.

2. The apparatus of Claim 1, wherein said enhanced stop band attenuation is provided at least above 30KHz.

3. The apparatus of Claim 1, wherein said filter apparatus (200) comprises a fourth order elliptical filter.

4. The apparatus of Claims 2 or 3, wherein said enhanced return loss performance comprises return loss of at least 10db.

5. The apparatus of Claim 1, wherein said at least one RLC circuit comprises first and second RLC circuits, and said apparatus further comprises a second switching (264) apparatus electrically coupled between said first and second RLC circuits.

6. The apparatus of Claim 1, wherein said selective alteration of the configuration of said signal filter apparatus is determined at least in part in response to electrical current flowing in said signal filter apparatus.

7. The apparatus of Claim 6, wherein said enhanced return loss performance comprises return loss of at least 10db.

8. The apparatus of any Claims 6 or 7, wherein said filter apparatus comprises a fourth order elliptical filter.

9. The apparatus of Claim 1, further comprising voltage protection apparatus, said protection apparatus being adapted to protect said dynamic switching apparatus from voltage transients present within said telecommunications signal conditioning apparatus.

10. The apparatus of Claim 9, wherein said voltage protection apparatus comprises a plurality of Zener diodes (276, 278) disposed in electrical parallel with respective ones of said dynamic switching apparatus (262, 264).

11. The apparatus of Claim 1, wherein said at least one RLC circuit is adapted to generate a positive phase impedance in a predetermined signal band.

12. The apparatus of Claim 11, wherein said predetermined signal band comprises approximately 2-3 KHz.

13. The apparatus of Claims 1 or 2, further comprising a third set of terminals (250), said third set of terminals (250) being in electrical communication with said first set of terminals (204) and adapted to interface with a second telecommunications line, said second line being in data communication with an xDSL modulator/demodulator apparatus.

14. The apparatus of Claim 1, wherein said signal filter apparatus comprises a plurality of inductors, each of said inductors having a respective coil.

15. The apparatus of Claim 1, wherein said signal filter apparatus comprises a plurality of dual bobbin magnetically shielded inductors.

16. The apparatus of Claim 1, wherein said filter apparatus comprises a plurality of inductors and capacitors arranged so as to produce fourth-order elliptical filtering of said signals.

17. The apparatus of Claim 16, wherein said plurality of inductors and capacitors comprise four inductors and three capacitors respectively, two of said four inductors being disposed in serial within each of two parallel electrical pathways formed between line-side and extension-side terminals of said splitter apparatus, said three capacitors acting as bridge capacitors between said two electrical pathways.

18. The apparatus of Claim 1, wherein said impedance correction apparatus comprises two RLC circuits, said signal conditioning apparatus further comprising:
a reed switch element (264) operatively coupled to at least one of two inductors (L5) within said RLC circuits.

19. The apparatus of Claim 1, further comprising:
a first inductor (L5A) disposed in electrical series with a second inductor (L4), said first inductor being part of said impedance correction apparatus;
a third inductor (L5B) disposed in electrical series with a fourth inductor (L3), said third inductor being part of said impedance correction apparatus;
wherein said first and second inductors are disposed in electrical series between a first set of said first and second terminals; and
said third and fourth inductors are disposed in electrical series between a second set of said first and second terminals.

20. The apparatus of Claim 19, further comprising fifth and sixth inductors (L1, L2) disposed in electrical series with said first and second inductors, respectively.

21. The apparatus of Claim 20, wherein said fifth and sixth inductors are disposed electrically between said first and third inductors and said first terminals.

22. The apparatus of Claims 19 or 21, wherein said switch apparatus comprises a reed switch element (K2).

23. The apparatus of Claims 19 or 21, further comprising first and second capacitors in electrical parallel with respective ones of said second and fourth inductors.

24. The apparatus of Claim 23, further comprising a third capacitor bridging between first ends of said second and fourth inductors, respectively.

25. The apparatus of Claim 24, further comprising a fourth capacitor bridging between second ends of said second and fourth inductors, respectively.

26. A method of conditioning a digital subscriber line (DSL) signal using a circuit according to claim 1 so as to provide both at least predetermined minimum levels of stop band attenuation above a predetermined frequency, and voice band return loss greater than a predetermined minimum value, the method comprising:
filtering at least a portion of said signal;
switching at least a portion of said filter circuit, said act of switching selectively altering the configuration of said filter circuit so as to provide at least in part said minimum level of stop band attenuation; and
selectively adjusting the impedance of said circuit to provide said return loss greater than said minimum value.

27. The method of Claim 26, wherein said frequency comprises 30 kHz.

28. The method of Claim 27, wherein said act of selectively altering the configuration comprises dynamically varying capacitance based on the magnitude of current flowing through at least a portion of said circuit.

29. The method of Claim 28, wherein said act of dynamically varying comprises selectively opening and closing a plurality of switch elements disposed within said circuit.

30. The method of Claim 27, wherein said act of filtering comprises filtering said DSL signal using a fourth-order elliptical filter.

31. The method of Claim 26, wherein said act of adjusting the impedance comprises generating a positive phase impedance in a predetermined signal band.

32. The method of Claim 31, wherein said act of generating comprises generating a positive phase impedance in the 2-3 KHz signal band.

33. The method of Claim 26, further comprising dynamically varying the capacitance of said circuit based at least in part on the magnitude of current flowing through at least a portion of said circuit as part of said act of filtering.

34. The method of Claim 33, wherein said act ofselectively adjusting the impedance of said circuit comprises placing a differential resonance impedance in series with said circuit.

35. The method of Claim 34, wherein said act of filtering comprises filtering said signal using a fourth order elliptical filter.

36. A telecommunications subscriber-side system, comprising a plurality of signal conditioning circuits each comprising the apparatus of any of Claims 1 to 25.

## Patentansprüche

1. Fernmeldesignalumformungsgerät, das angepasst ist sowohl verbesserte Sperrdämpfung als auch verbesserte Sprachband-Rückflussdämpfungsleistung, bereitzustellen, wobei das Gerät umfasst:
erste Klemmen (204), die zum Anschluss an eine erste Übertragungsleitung angepasst sind, wobei besagte Übertragungsleitung angepasst ist, Signale zu tragen, die erste und zweite Komponenten aufweisen;
zweite Klemmen (240), die zum Anschluss an ein Nebenanschlussgerät angepasst sind;
Impedanzkorrekturgerät (270, 290, 292, 294, 296) in elektrischer Kommunikation mit besagten ersten Klemmen 204) und angepasst Rückflussdämpfung in Bezug auf besagte Sprachkomponente der besagten Signale zu ändern, wobei besagtes Impedanzkorrekturgerät mindestens eine parallele RLC-Schaltung aufweist; und
Signalfiltergerät (200),das mindestens erste und zweite parallele LC-Schaltungen (224, 234, 226, 236) aufweist, die elektrisch zwischen besagten zweiten Klemmen (240) und besagtem Impedanzkorrekturgerät (270, 290, 292, 296) angeordnet sind, wobei besagtes Filtergerät (200) weiter Schaltgerät (262) aufweist, das elektrisch zwischen besagten ersten und zweiten parallelen LC-Schaltungen (224, 234, 226, 236) angeordnet und angepasst ist, selektiv die Konfiguration des besagten Signalfiltergeräts zu ändern, um die Kapazitanz des besagten Filtergeräts zu erhöhen, wobei besagte Erhöhung an Kapazitanz wenigstens teilweise besagte verbesserte Sperrdämpfung bereitstellt.

2. Gerät nach Anspruch 1, wobei besagte verbesserte Sperrdämpfung mindestens über 30 kHz bereitgestellt wird.

3. Gerät nach Anspruch 1, wobei besagtes Filtergerät (200) ein elliptisches Filter vierter Ordnung aufweist.

4. Gerät nach Ansprüchen 2 oder 3, wobei besagte verbesserte Rückflussdämpfungsleistung Rückflussdämpfung von mindestens 10db aufweist.

5. Gerät nach Anspruch 1, wobei besagte mindestens eine RLC-Schaltung erste und zweite RLC-Schaltungen aufweist, und besagtes Gerät weiter ein zweites Schaltgerät (264) aufweist, das zwischen besagten ersten und zweiten RLC-Schaltungen elektrisch gekoppelt ist.

6. Gerät nach Anspruch 1, wobei besagte selektive Änderung der Konfiguration des besagten Signalfiltergeräts wenigstens teilweise als Reaktion auf den elektrischen Strom bestimmt wird, der in besagtem Filtergerät fließt.

7. Gerät nach Anspruch 6, wobei besagte verbesserte Rückflussdämpfungsleistung Rückflussdämpfung von mindestens 10db aufweist.

8. Gerät nach einem beliebigen der Ansprüche 6 oder 7, wobei besagtes Filtergerät ein elliptisches Filter vierter Ordnung aufweist.

9. Gerät nach Anspruch 1, das weiter ein Spannungsschutzgerät aufweist, wobei besagtes Spannungsschutzgerät angepasst ist, besagtes dynamische Schaltgerät vor vorübergehenden Spannungsabweichungen im besagten Fernmeldesignalumformungsgerät zu schützen.

10. Gerät nach Anspruch 9, wobei besagtes Spannungsschutzgerät eine Mehrheit von Zenerdioden (276, 278) aufweist, die in elektrischer Parallele mit entsprechenden Dioden des besagten dynamischen Schaltgeräts (262, 264) angeordnet sind.

11. Gerät nach Anspruch 1, wobei mindestens eine RLC-Schaltung angepasst ist, eine positive Phasenimpedanz in einem vorbestimmten Signalband zu generieren.

12. Gerät nach Anspruch 11, wobei besagtes vorbestimmte Signalband ca. 2-3 kHz umfasst.

13. Gerät nach Ansprüchen 1 oder 2, das weiter einen dritten Satz Klemmen (250) aufweist, wobei besagter dritte Satz Klemmen (250) in elektrischer Kommunikation mit besagtem ersten Satz Klemmen (204) steht und zum Anschluss an eine zweite Übertragungsleitung angepasst ist, wobei besagte zweite Leitung in Datenkommunikation mit einem xDSL-Modulator-/Demodulatorgerät steht.

14. Gerät nach Anspruch 1, wobei besagtes Signalfiltergerät eine Mehrheit von Induktoren umfasst und jeder der besagten Induktoren eine entsprechende Magnetspule aufweist.

15. Gerät nach Anspruch 1, wobei besagtes Signalfiltergerät eine Mehrheit magnetisch abgeschirmter Doppelspuleninduktoren aufweist.

16. Gerät nach Anspruch 1, wobei besagtes Filtergerät eine Mehrheit von Induktoren und Kondensatoren umfasst, die angeordnet sind, elliptische Filterung vierter Ordnung besagter Signale zu produzieren.

17. Gerät nach Anspruch 16, wobei besagte Mehrheit von Induktoren und Kondensatoren vier Induktoren bzw. drei Kondensatoren umfasst, wobei zwei der besagten vier Induktoren seriell in jedem der zwei parallelen elektrische Pfade angeordnet sind, die zwischen den leitungsseitigen und nebenanschlussseitigen Klemmen des besagten Teilergeräts angeordnet sind, wobei besagte drei Kondensatoren als Brückenkondensatoren zwischen besagten zwei elektrischen Pfaden fungieren.

18. Gerät nach Anspruch 1, wobei besagtes Impedanzkorrekturgerät zwei RLC-Schaltungen aufweist und besagtes Signalumformungsgerät weiter umfasst:
ein Reed-Schaltelement (264), das funktionsfähig an wenigstens einen der zwei Induktoren (L5) in besagten RLC-Schaltungen gekoppelt ist.

19. Gerät nach Anspruch 1, das weiter umfasst:
einen ersten Induktor (L5A), der elektrisch in Reihe mit einem zweiten Induktor (L4) angeordnet ist, wobei besagter erste Induktor Teil des besagten Impedanzkorrekturgeräts ist;
einen dritten Induktor (L5B), der elektrisch in Reihe mit einem vierten Induktor (L3) angeordnet ist, wobei besagter dritte Induktor Teil des besagten Impedanzkorrekturgeräts ist;
wobei besagte ersten und zweiten Induktoren elektrisch in Reihe zwischen einem ersten Satz besagter ersten und zweiten Klemmen angeordnet sind; und
wobei besagte dritten und vierten Induktoren elektrisch in Reihe zwischen einem zweiten Satz besagter ersten und zweiten Klemmen angeordnet sind.

20. Gerät nach Anspruch 19, das weiter fünfte und sechste Induktoren (L1, L2) aufweist, die elektrisch in Reihe mit besagten ersten bzw. zweiten Induktoren angeordnet sind.

21. Gerät nach Anspruch 20, wobei besagte fünften und sechsten Induktoren elektrisch zwischen besagten ersten und dritten Induktoren und besagten ersten Klemmen angeordnet sind.

22. Gerät nach Ansprüchen 19 oder 21, wobei besagtes Schaltgerät ein Reed-Schaltelement (K2) aufweist.

23. Gerät nach Ansprüchen 19 oder 21, das weiter erste und zweite Kondensatoren in elektrischer Parallele mit entsprechenden Kondensatoren besagter zweiten und vierten Induktoren aufweist.

24. Gerät nach Anspruch 23, das weiter einen dritten Kondensator aufweist, der eine Brücke zwischen ersten Enden besagter zweiten bzw. vierten Induktoren bildet.

25. Gerät nach Anspruch 24, das weiter einen vierten Kondensator aufweist, der eine Brücke zwischen zweiten Enden besagter zweiten bzw. vierten Induktoren bildet.

26. Verfahren zur Umformung des Signals einer digitalen Teilnehmerleitung (DSL) unter Verwendung einer Schaltung nach Anspruch 1, um sowohl wenigstens vorbestimmte Minimumlevel von Sperrdämpfung über einer vorbestimmten Frequenz als auch Sprachbandrückflussdämpfung größer als ein vorbestimmter Mindestwert bereitzustellen, wobei das Verfahren umfasst:
Filterung wenigstens eines Teils des besagten Signals;
Schalten wenigstens eines Teils besagter Filterschaltung, wobei besagter Schaltvorgang selektiv die Konfiguration der besagten Filterschaltung ändert, um wenigstens teilweise besagten Minimumlevel von Sperrbanddämpfung bereitzustellen; und
selektive Einstellung der Impedanz der besagten Schaltung, um besagte Rückflussdämpfung größer als besagter Mindestwert bereitzustellen.

27. Verfahren nach Anspruch 26, wobei besagte Frequenz 30 kHz umfasst.

28. Verfahren nach Anspruch 27, wobei besagter Vorgang selektiver Änderung der Konfiguration dynamisch variierende Kapazitanz, beruhend auf der Größenordnung des durch wenigstens einen Teil besagter Schaltung fließenden Stroms, umfasst.

29. Verfahren nach Anspruch 28, wobei besagter Vorgang dynamischer Änderung selektives Öffnung und Schließen einer Mehrheit von Schaltelementen umfasst, die in besagter Schaltung angeordnet sind.

30. Verfahren nach Anspruch 27, wobei besagter Filterungsvorgang das Filtern besagten DSL-Signals unter Einsatz eines elliptischen Filters vierter Ordnung umfasst.

31. Verfahren nach Anspruch 26, wobei besagter Einstellvorgang der Impedanz das Generieren einer positiven Phasenimpedanz in einem vorbestimmten Signalband umfasst.

32. Verfahren nach Anspruch 31, wobei besagter Generiervorgang das Generieren einer positiven Phasenimpedanz im Signalband von 2-3 kHz umfasst.

33. Verfahren nach Anspruch 26, das weiter dynamisches Variieren der Kapazitanz besagter Schaltung, wenigstens teilweise auf der Größenordnung des durch wenigstens einen Teil besagter Schaltung fließenden Stroms, als Teil des besagten Filterungsvorgangs umfasst.

34. Verfahren nach Anspruch 33, wobei besagter Vorgang selektiver Einstellung der Impedanz besagter Schaltung das Platzieren einer differenziellen Resonanzimpedanz in Reihe mit besagter Schaltung umfasst.

35. Verfahren nach Anspruch 34, wobei besagter Filterungsvorgang das Filtern besagten Signals unter Einsatz eines elliptischen Filters vierter Ordnung umfasst.

36. Teilnehmerseitiges Telekommunikationssystem, das eine Mehrheit von Signalumformungsschaltungen umfasst, wobei jede das Gerät eines der beliebigen Ansprüche 1 bis 25 umfasst.

## Revendications

1. Appareil de mise en forme de signaux de télécommunications adapté de façon à fournir à la fois une atténuation améliorée dans la bande affaiblie et une performance améliorée d'affaiblissement d'adaptation de la bande de fréquences vocales, comprenant
des premiers terminaux (204) adaptés de façon à relier une première ligne de télécommunications, ladite ligne de télécommunications étant adaptée de façon à acheminer des signaux ayant une première et une deuxième composante;
des deuxièmes terminaux (240) adaptés de façon à relier un dispositif de poste ;
un appareil de correction d'impédance (270, 290, 292, 294, 296) en communication électrique avec lesdits premiers terminaux et adapté de façon à modifier l'affaiblissement d'adaptation par rapport à ladite composante vocale desdits signaux, ledit appareil de correction d'impédance comprenant au moins un circuit RLC (à résistance-inductance-condensateur) parallèle ; et
un appareil de filtrage de signaux (200) comportant au moins un premier et un deuxième circuit LC (à inductance et à condensateur) parallèles (224, 234, 226, 236) disposés électriquement entre lesdits deuxièmes terminaux (240) et ledit appareil de correction d'impédance (270, 290, 292, 296), ledit appareil de filtrage des signaux (200) comportant en outre un appareil de commutation (262) disposé électriquement entre lesdits premier et deuxième circuits LC parallèles (224, 234, 226, 236) et adapté de façon à modifier sélectivement la configuration dudit appareil de filtrage des signaux afin d'augmenter la capacité dudit appareil de filtrage, ladite augmentation de capacité fournissant au moins partiellement ledit affaiblissement amélioré dans la bande affaiblie.

2. L'appareil de la revendication 1, ledit affaiblissement amélioré dans la bande affaiblie étant fourni au moins au-dessus de 30 KHz.

3. L'appareil de la revendication 1, ledit appareil de filtrage (200) comportant un filtre elliptique du quatrième ordre.

4. L'appareil de la revendication 2 ou 3, ladite performance améliorée performance d'affaiblissement d'adaptation comprenant un affaiblissement d'adaptation d'au moins 10 dB.

5. L'appareil de la revendication 1, ledit au moins un circuit RLC consistant en le premier et le deuxième circuit RLC, et ledit appareil comportant en outre un deuxième appareil de commutation (264) couplé électriquement entre lesdits premier et deuxième circuits RLC.

6. L'appareil de la revendication 1, ladite modification sélective de la configuration dudit appareil de filtrage des signaux étant déterminée au moins partiellement en réponse au courant électrique s'écoulant dans ledit appareil de filtrage des signaux.

7. L'appareil de la revendication 6, ladite performance améliorée d'affaiblissement d'adaptation consistant en un affaiblissement d'adaptation d'au moins 10 dB.

8. L'appareil de l'une quelconque des revendications 6 ou 7, ledit appareil de filtrage consistant en un filtre elliptique du quatrième ordre.

9. L'appareil de la revendication 1, comportant en outre un appareil de protection contre les surtensions, ledit appareil de protection étant adapté de façon à protéger ledit appareil de commutation dynamique contre les tensions transitoires présentes à l'intérieur dudit appareil de mise en forme des signaux de télécommunications.

10. L'appareil de la revendication 9, ledit appareil de protection contre les surtensions consistant en une pluralité de diodes Zener (276, 278) disposées en parallèle électrique avec celles respectives dudit appareil de commutation dynamique (262, 264).

11. L'appareil de la revendication 1, ledit au moins un circuit RLC étant adapté de façon à produire une impédance à phase positive dans une bande de signaux prédéterminée.

12. L'appareil de la revendication 11, ladite bande de signal prédéterminée consistant approximativement en 2 à 3 KHz.

13. L'appareil des revendications 1 ou 2, comportant en outre un troisième ensemble de terminaux (250), ledit troisième ensemble de terminaux (250) étant en communication électrique avec ledit premier ensemble de terminaux (204) et étant adapté de façon à relier une deuxième ligne de télécommunications, ladite deuxième ligne étant en communication de données avec un appareil modulateur/démodulateur xDSL.

14. L'appareil de la revendication 1, ledit appareil de filtrage des signaux consistant en une pluralité de bobines d'inductance, chacune desdites bobines d'inductance ayant une bobine respective.

15. L'appareil de la revendication 1, ledit appareil de filtrage des signaux consistant en une pluralité de bobines d'inductance à blindage anti-magnétique à double bobine.

16. L'appareil de la revendication 1, ledit appareil de filtrage des signaux consistant en une pluralité de bobines d'inductance et de condensateurs disposés de façon à produire un filtrage elliptique du quatrième ordre desdits signaux.

17. L'appareil de la revendication 16, ladite pluralité de bobines d'inductance et de condensateurs consistant en quatre bobines d'inductance et en trois condensateurs respectivement, deux desdites quatre bobines d'inductance étant disposées en série à l'intérieur de chacun de deux trajets électriques parallèles formés entre les terminaux du côté ligne et du côté poste dudit appareil séparateur, lesdits trois condensateurs agissant comme des condensateurs en dérivation entre lesdits deux trajets électriques.

18. L'appareil de la revendication 1, ledit appareil de correction d'impédance consistant en deux circuits RLC, ledit appareil de mise en forme des signaux comportant en outre :
un élément commutateur à lames (264) coupé opérationnellement à au moins une des deux bobines d'inductance (L5) à l'intérieur desdits circuits RLC.

19. L'appareil de la revendication 1, comportant en outre :
une première bobine d'inductance (L5A) disposée en série électrique avec une deuxième bobine d'inductance (L4), ladite troisième bobine d'inductance faisant partie dudit appareil de correction d'impédance ;
une troisième bobine d'inductance (L5B) disposée en série électrique avec une quatrième bobine d'inductance (L3), ladite troisième bobine d'inductance faisant partie dudit appareil de correction d'impédance ;
ladite première et deuxième bobines d'inductance étant disposées en série électrique entre un premier ensemble desdits premier et deuxième terminaux ; et
lesdites troisième et quatrième bobines d'inductance étant disposées en série électrique entre un deuxième ensemble desdits premier et deuxième terminaux.

20. L'appareil de la revendication 19, comportant en outre une cinquième et une sixième bobine d'inductance (L1, L2) disposées en série électrique avec lesdites première et deuxième bobines d'inductance, respectivement.

21. L'appareil de la revendication 20, lesdites cinquième et sixième bobines d'inductance étant disposées électriquement entre lesdites première et troisième bobines d'inductance et lesdits premiers terminaux.

22. L'appareil des revendications 19 ou 21, ledit appareil de commutation comportant un élément commutateur à lames (K2).

23. L'appareil des revendications 19 ou 21, comportant en outre un premier et un deuxième condensateur en parallèle électrique avec celles respectives desdites deuxième et quatrième bobines d'inductance.

24. L'appareil de la revendication 23, comportant en outre un troisième condensateur monté en dérivation entre les premières extrémités desdites deuxième et quatrièmes bobines d'inductance, respectivement.

25. L'appareil de la revendication 24, comportant en outre un quatrième condensateur monté en dérivation entre les deuxièmes extrémités desdites deuxième et quatrième bobines d'inductance, respectivement.

26. Procédé de mise en forme d'un signal de ligne d'abonné numérique (DSL) en utilisant un circuit selon la revendication 1 afin de fournir à la fois au moins des niveaux minimum prédéterminés d'atténuation dans la bande affaiblie au-dessus d'une fréquence prédéterminée, et un affaiblissement d'adaptation de la bande de fréquences vocales plus grand qu'une valeur minimum prédéterminée, ce procédé comprenant :
le filtrage d'au moins une portion dudit signal ;
la commutation d'au moins une portion dudit circuit de filtrage, ledit acte de commutation modifiant sélectivement la configuration dudit circuit de filtrage afin de fournir au moins partiellement ledit niveau minimum d'atténuation dans la bande affaiblie ; et
le réglage sélectif de l'impédance dudit circuit afin de fournir un dit affaiblissement d'adaptation de la bande de fréquences vocales plus grand que ladite valeur minimum.

27. Le procédé de la revendication 26, ladite fréquence consistant en 30 KHz.

28. Le procédé de la revendication 27, ledit acte de modification sélective de la configuration consistant en la modification dynamique de la capacité en se basant sur l'intensité du courant s'écoulant à travers au moins une portion dudit circuit.

29. Le procédé de la revendication 28, ledit acte de modification dynamique consistant en l'ouverture et la fermeture sélectives d'une pluralité d'éléments commutateurs disposés à l'intérieur dudit circuit.

30. Le procédé de la revendication 27, ledit acte de filtrage consistant en le filtrage dudit signal DSL en utilisant un filtre elliptique du quatrième ordre.

31. Le procédé de la revendication 26, ledit acte de réglage de l'impédance consistant en la production d'une impédance à phase positive dans une bande de signaux prédéterminée.

32. Le procédé de la revendication 31, ledit acte de production comprenant la production d'une impédance à phase positive dans la bande de signaux de 2-3 KHz.

33. Le procédé de la revendication 26, consistant en outre en la variation dynamique de la capacité dudit circuit en se basant au moins partiellement sur l'intensité du courant s'écoulant à travers au moins une portion dudit circuit comme faisant partie dudit acte de filtrage.

34. Le procédé de la revendication 33, ledit acte de réglage sélectif de l'impédance dudit circuit consistant en la mise en place d'une impédance de résonance différentielle en série avec ledit circuit.

35. Le procédé de la revendication 34, ledit acte de filtrage consistant en le filtrage dudit signal en utilisant un filtre elliptique du quatrième ordre.

36. Système de télécommunications côté abonné, consistant en une pluralité de circuits de mise en forme de signaux comportant chacun un l'appareil de l'une quelconque des revendications 1 à 25.
